Europäisches Patentamt

European Patent Office

Office européen des brevets

(19)

(11) **EP 1 635 392 A1**

(12) **EUROPEAN PATENT APPLICATION**
published in accordance with Art. 158(3) EPC

(43) Date of publication:
**15.03.2006 Bulletin 2006/11**

(51) Int Cl.:
*H01L 27/092* (1990.01)    *H03G 11/00* (1968.09)
*H03K 5/00* (1968.09)    *H01L 29/78* (1974.07)
*H01L 21/336* (1990.01)

(21) Application number: **04745813.8**

(22) Date of filing: **11.06.2004**

(86) International application number:
**PCT/JP2004/008219**

(87) International publication number:
**WO 2004/112142 (23.12.2004 Gazette 2004/52)**

(84) Designated Contracting States:
**DE**

(30) Priority: **13.06.2003 JP 2003170105**

(71) Applicants:
• **KABUSHIKI KAISHA TOYOTA JIDOSHOKKI**
**Kariya-shi,**
**Aichi-ken 448-8671 (JP)**
• **Niigata Seimitsu Co., Ltd.**
**Niigata 943-0834 (JP)**
• **OHMI, Tadahiro**
**Sendai-shi,**
**Miyagi 980-0813 (JP)**

(72) Inventors:
• **OHMI, Tadahiro**
**Sendai-shi, Miyagi 9800813 (JP)**

• **NISHIMUTA, Takefumi,**
**c/o TOYOTA JIDOSHOKKI K.K.**
**Kariya-shi, Aichi 4488671 (JP)**
• **MIYAGI, Hiroshi,**
**c/o NIIGATA SEIMITSU CO., LTD.**
**Joetsu-shi, Niigata 9430834 (JP)**
• **SUGAWA, Shigetoshi**
**Sendai-shi, Miyagi 9800861 (JP)**
• **TERAMOTO, Akinobu**
**Sendai-shi, Miyagi 9830037 (JP)**

(74) Representative: **TBK-Patent**
**Bavariaring 4-6**
**80336 München (DE)**

(54) **LIMITER CIRCUIT AND SEMICONDUCTOR INTEGRATED CIRCUIT THEREOF**

(57)    A rectangular parallelepiped p-channel MOS transistor 21 having a height of $H_B$ and a width of $W_B$ is formed on a silicon substrate, and a gate oxide film is formed on a part of the top surface and the side surface of the p-channel MOS transistor 21. A source and a drain are formed on both sides of a gate electrode 26 to form a MOS transistor. A differential amplification circuit including MOS transistors 61 and 62 configures a limiter circuit. Thus, the gain of the limiter circuit can be designed large.

F I G. 4

EP 1 635 392 A1

## Description

## Technical Field

The present invention relates to a limiter circuit formed on a semiconductor integrated circuit substrate, and the semiconductor integrated circuit.

## Background Art

Conventionally, in the production process of a MOS transistor, a thermal oxide film is formed on the silicon surface at a high temperature of 800°C, and a MOS transistor is produced using the thermal oxide film as a gate insulating film.

It is requested to form an oxide film at a lower temperature environment to enhance the production efficiency of a semiconductor. To realize the request, for example, the patent document 1 discloses the technology of forming an insulating film in a low temperature plasma atmosphere.

An FM receiver uses a limiter circuit for obtaining the constant amplitude of an FM-modulated signal.

The patent document 2 describes forming a three-dimensionally structured gate on a silicon substrate.

Patent Document 1: Japanese Published Patent Application No. 2002-261091

Patent Document 2: Japanese Published Patent Application No. 2002-110963 (Fig. 1)

There has been a demand for reduction of a DC offset generated by an amplification circuit in the limiter circuit.

When a limiter circuit is configured with a plurality of serially connected amplification circuits, there has been the problem that a DC offset amplified at the previous stage saturates the amplification circuit at the subsequent stage. Therefore, in the conventional technology, a capacitor is inserted between amplification circuits to cut the AC components. A gain of a limiter is also restricted.

## Disclosure of the Invention

The present invention aims at obtaining a large gain of a limiter circuit, and reducing the distortion of a signal in a limiter circuit.

The limiter circuit according to the present invention is formed on a substrate of a semiconductor integrated circuit includes a MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion.

An inert gas is formed by, for example, argon, krypton, xenon, etc.

According to the invention, the evenness level can be enhanced, and the variance of the features (for example, a threshold voltage, etc.) of an MIS field-effect transistor can be decreased. As a result; since the DC offset generated in the limiter circuit and the 1/f noise can be reduced, the gain of the limiter circuit can be designed large. It is not necessary to provide a capacitor in the limiter circuit to cut the AC component.

Furthermore, the influence of the channel length modulation effect can be suppressed and the distortion of a signal in the limiter circuit can be decreased by forming a gate in a three-dimensional structure and a gate insulating film in the low temperature plasma atmosphere.

In addition, by forming the gate insulating film on a different crystal surface in the three-dimensional structure, the current drive capability of the MIS field-effect transistor can be improved and the device area of the MIS field-effect transistor on the primary surface of the silicon substrate can be smaller.

In the above-mentioned invention, a channel is formed on the first crystal surface of the top surface of the projecting portion and the second crystal surface of the side surface, and the channel width of the MIS field-effect transistor is at least a total of the channel width of the top surface and the channel width of the side surface.

With the above-mentioned configuration, channels are formed on two crystal surfaces, thereby improving the characteristics of the MIS field-effect transistor and the current drive capability.

In the projecting portion of the present invention, the top surface is formed by the surface (100) of silicon, and the side surface is formed by the surface (110) of silicon, and the source and the drain are formed in the right and left areas of the projecting portion enclosing the gate and the projecting portion of the silicon substrate.

With the above-mentioned configuration, a channel can be formed on the surfaces (100) and (110) of the silicon substrate, thereby improving the current drive capability of the MIS field-effect transistor.

In the above-mentioned invention, the limiter circuit includes a p-channel MIS field-effect transistor and an n-channel MIS field-effect transistor, and the gate width of the top surface and the side surface of the projecting portion of the p-channel MIS field-effect transistor is set such that the current drive capability of the p-channel MIS field-effect transistor can be substantially equal to the current drive capability of the n-channel MIS field-effect transistor.

With the above-mentioned configuration, the parasitic capacity of the p-channel MIS field-effect transistor can be substantially equal to the parasitic capacity of the n-channel MIS field-effect transistor. Thus, the feature of the amplification circuit can be improved, and the noise can be reduced during switching.

In the above-mentioned invention, the limiter circuit includes the first and second MIS field-effect transistors forming a differential amplification circuit and receiving an FM-modulated signal at the gate, and the third MIS field-effect transistor forming a constant current circuit commonly connected to the source or drain of the first and second MIS field-effect transistor.

With the above-mentioned configuration, the DC offset and the 1/f noise of the differential amplification circuit formed by the first and second MIS field-effect transistors and the constant current circuit formed by the third MIS field-effect transistor can be reduced, and the influence of the channel length modulation effect of the circuits can also be reduced.

The semiconductor integrated circuit of the present invention includes on the same silicon substrate: a circuit including a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a limiter circuit having a differential amplification circuit including the p-channel MIS field-effect transistor or the n-channel MIS field-effect transistor.

According to the invention, since the DC offset generated in the limiter circuit and the 1/f noise can be reduced, the gain of the limiter circuit can be designed large. It is not necessary to provide a capacitor in the limiter circuit to cut the AC component.

Furthermore, the influence of the channel length modulation effect can be suppressed and the distortion of a signal in other circuits and limiter circuits can be decreased by forming a gate in a three-dimensional structure and a gate insulating film in the low temperature plasma atmosphere.

Since the characteristics of the p-channel MIS field-effect transistor and the n-channel MIS field-effect transistor of other circuits can be prepared, the DC offset and the 1/f noise of other circuits can be reduced.

In addition, by forming a gate insulating film on a different crystal surface in the three-dimensional structure, the current drive capability of the MIS field-effect transistor can be improved and the device area of the MIS field-effect transistor on the primary surface of the silicon substrate can be smaller.

In the above-mentioned invention, the gate widths of the top surface and the side surface of the p-channel MIS field-effect transistor and the n-channel MIS field-effect transistor are set such that the current drive capability of the p-channel MIS field-effect transistor can be substantially equal to the current drive capability of the n-channel MIS field-effect transistor.

In the above-mentioned invention, the limiter circuit is configured by a CMOS circuit including the p-channel MIS field-effect transistor and the n-channel MIS field-effect transistor.

With the above-mentioned configuration, the parasitic capacity of the p-channel MOS transistor can be substantially equal to the parasitic capacity of the n-channel MOS transistor. Thus, for example, the noise during switching can be reduced by setting it symmetrically between positive and negative areas.

**Brief Description of the Drawings**

Fig. 1 is a sectional view of the plasma device using a radial line slot antenna;
Fig. 2 shows the comparison of the interface level density;
Fig. 3 shows the structure of a silicon substrate produced in the semiconductor production process according to an embodiment of the present invention;
Fig. 4 shows the structure of the MOS transistor produced in the semiconductor production process according to an embodiment of the present invention; and
Fig. 5 shows a limiter circuit.

**Best Mode for Carrying Out the Invention**

An embodiment of the present invention is explained below by referring to the attached drawings. Described below first is a semiconductor production process of forming a gate insulating film (for example, an oxide film) on the silicon substrate at a low temperature using an inert gas in a plasma state, and producing a MIS (metal insulator semiconductor) field-effect transistor. The method for forming a gate insulating film is disclosed in Japanese Published Patent Application No. 2002-261091.

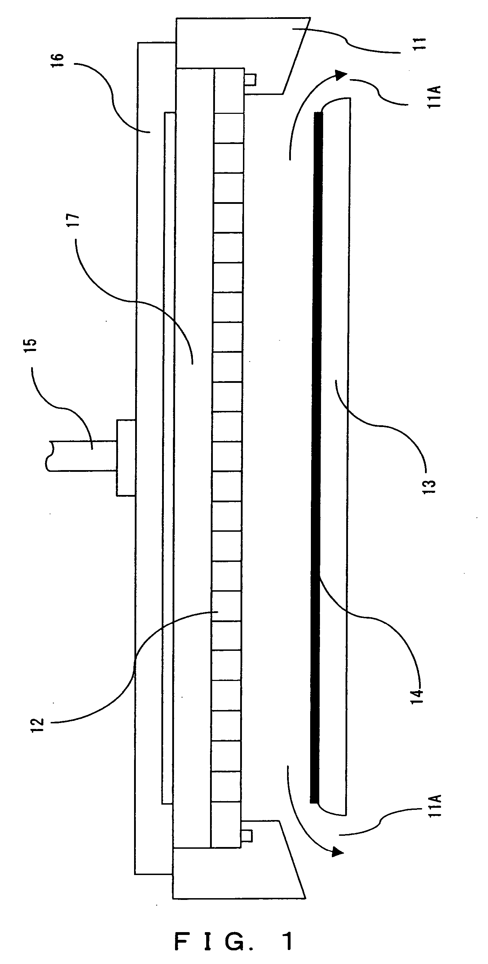

Fig. 1 is a sectional view of the plasma device using a radial line slot antenna to be used in the semiconductor production process.

A vacuum is produced in a vacuum container (processing chamber) 11, an argon gas (Ar) if introduced from a shower plate 12, the Ar gas is exhausted from an outlet 11A, and the gas is switched to a krypton gas. The pressure in the processing chamber 11 is set to 133 Pa (1 Torr).

Then, a silicon substrate 14 is placed on a sample table 13 having a heating mechanism, and the temperature of a sample is set to approximately 400°C. If the temperature of the silicon substrate 14 is between 200°C and 550°C, the following result is almost the same.

The silicon substrate 14 is cleansed with noble fluoride acid in the pretreatment process performed immediately before, and the unused coupling of silicon on the surface is terminated with hydrogen as a result.

Next, a microwave at the frequency of 2.45 GHz is supplied from a coaxial waveguide 15 to a radial line slot antenna 16, and the microwave is introduced from the radial line slot antenna 16 to the processing chamber 11 through a dielectric plate 17 provided in a portion of the wall. The introduced microwave pumps the Kr gas introduced from the shower plate 12 to the processing chamber 11. As a result, high density Kr plasma is formed immediately below the shower plate 12. If the frequency of the provided microwave is between 900 MHz and 10 GHz, the following results are almost the same.

With the configuration shown in Fig. 1, the interval between the shower plate 12 and the silicon substrate 14 is set to about 6 cm. The film can be formed at a higher speed with the smaller interval.

The plasma can be pumped by introducing the microwave to the processing chamber using another method without limiting the plasma device to a device using a radial line slot antenna.

By exposing the silicon substrate 14 to the plasma pumped by the Kr gas, the surface of the silicon substrate 14 receives the irradiation of Kr ion of low energy, and the surface terminated hydrogen is removed.

Then, $Kr/O_2$ mixed gas having the partial pressure ratio of 97/3 is introduced from the shower plate 12. At this time, the pressure in the processing chamber is to be kept at approximately 133 Pa (1 Torr). In the high density pumped plasma as a mixture of a Kr gas and an $O_2$ gas, the Kr* and the $O_2$ molecule in the intermediate pumped state conflict with each other, and a large amount of atomic oxygen O* can be efficiently generated.

In the present embodiment, the surface of the silicon substrate 14 is oxidized by the atomic oxygen 0* . In the conventional thermal oxidation method, oxidation is performed by an $O_2$ molecule and an $H_2O$ molecule, and a very high process temperature over 800 °C is required. In the oxidization process using the atomic oxygen performed in the present embodiment, the oxidization process at a very low temperature of approximately 400°C can be performed. To extend the conflict opportunity between Kr* and $O_2$, it is desired that a higher pressure is kept in the processing chamber. However, if the pressure is too high, the generated O* conflict with each other and is returned to an $O_2$ molecule. Therefore, the optimum gas pressure is to be maintained.

When a desired thickness of a silicon oxide film (silicon compound layer) is formed, the introduction of the microwave power is stopped to terminate the plasma pumping, and the $Kr/O_2$ mixture gas is replaced with an Ar gas, thereby terminating the oxidization process. The Ar gas is used before and after the present process to use a gas less expensive than the Kr as a purge gas. The Kr gas used in this process is collected for recycling.

After forming the above-mentioned oxide film, an electrode forming process, a protective film forming process, a hydrogen sintering process, etc. are performed to generate a semiconductor integrated circuit including a transistor and a capacitor.

As a result of measuring the hydrogen content in the silicon oxide film formed in the above-mentioned procedure, it is lower than $10^{12}$ /cm$^2$ in a surface density conversion on the silicon oxide film of the film thickness of 3nm. Especially, on the oxide film having a small leak current, the hydrogen content in the silicon oxide film is $10^{11}$/cm$^2$ or less in the surface density conversion. On the other hand, the oxide film not exposed to the Kr plasma before forming the oxide film contains hydrogen of $10^{12}$/cm$^2$ or more in the surface density conversion.

When the oxidization process is performed with the $Kr/O_2$ gas introduced after removing the terminated hydrogen by irradiation with Kr plasma as described above, the leak current at the same voltage as the silicon oxide film formed by the conventional microwave plasma oxidization is reduced by two or three digits of the leak current, thereby obtaining a very excellent low leak feature. The improvement of the leak current feature has been confirmed in the production of an integrated circuit using the silicon oxide film having the film thickness up to about 1.7 nm.

When the surface direction dependency of the silicon/silicon oxide film interface level density is measured relating to the silicon oxide film obtained in the above-mentioned semiconductor production process, a very low interface level density of about $1 \times 10^{10}$ eV$^{-1}$ cm$^{-2}$ is obtained any of the surface direction of the silicon surface.

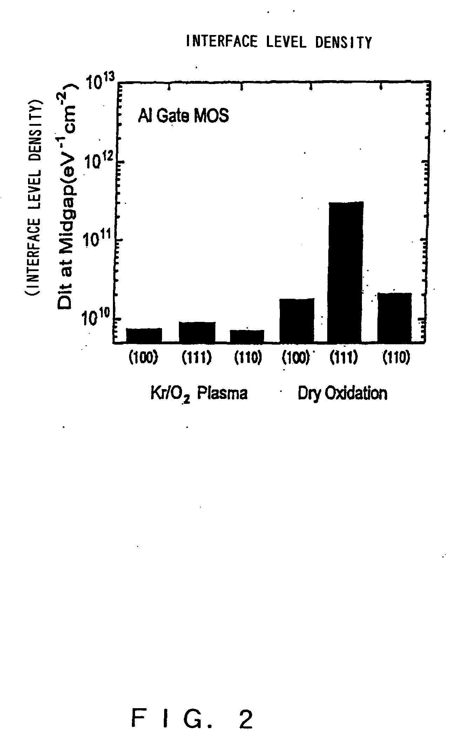

Fig. 2 shows the Kr/O$_2$ film formed by the above-mentioned semiconductor production process on each of the surfaces (100), (110), and (111) of a silicon substrate, and a result of measuring the interface level density of the conventional thermal oxide film.

As shown in Fig. 2, when the Kr/O$_2$ film is generated, the interface level density of the semiconductor on any of the surfaces (100), (110), and (111) is $10^{10}$ eV$^{-1}$ cm$^{-2}$ or lower. On the other hand, the interface level density of the thermal oxide film formed in the atmosphere higher than the conventional 800°C is 1.1 times greater or more on the surface (100), and in the above-mentioned semiconductor production process, a high quality insulating film of a low interface level density can be formed.

By lowering the interface level density, the probability of recombining a carrier can be reduced, thereby lowering the 1/f noise.

Relating to the electric features such as the pressure-resistant feature, the hot carrier resistance, the electric charge QBD (charge-to-breakdown) up to the destruction of the silicon oxide film when a stress current flows, etc. and the reliability feature, the oxide film formed in the semiconductor production process indicates good features equivalent to or higher than the conventional thermal oxide film.

As described above, by performing the high grade silicon oxidization process on silicon in all surface directions at a low temperature of 400°C by performing the silicon oxidization process using Kr/O$_2$ high density plasma after removing the surface terminated hydrogen. It is considered that the above-mentioned effect can be obtained by a decreasing hydrogen content in the oxide film by removing the terminated hydrogen, and by containing an inert gas (Kr for example) in the oxide film. By a small amount of hydrogen in the oxide film, there is no weak coupling of elements in the silicon oxide film, and by containing Kr, the stress in the film or on the Si/SiO$_2$ interface is moderated. As a result, the electric characteristic of the silicon oxide film can be largely improved.

In the above-mentioned semiconductor production process, it is considered that the hydrogen density of $10^{12}$/cm$^2$ or less in the surface density conversion, or $10^{11}$/cm$^2$ or less as a desired condition, and Kr of $5 \times 10^{11}$ /cm$^2$ or less contribute to the improvement of the electric characteristics and reliability characteristics of the silicon oxide film.

In the above-mentioned semiconductor process, a silicon nitride film and a silicon oxide and nitride film can be formed using a mixture of an inert gas and a NH$_3$ gas and a mixture of an inert gas, O$_2$, and NH$_3$.

The effect obtained by forming a nitride film is mainly based on the presence of hydrogen in plasma even after removing the surface terminated hydrogen. By the hydrogen in plasma, the dangling bond in the silicon nitride film and on the interface forms a coupling of Si-H and N-H and is terminated, and, as a result, the electronic trap in the silicon nitride film and on the interface disappear.

It is considered that the effect obtained by forming an oxide and nitride film is caused not only by the decrease in the hydrogen content in the oxide and nitride film by removing the terminated hydrogen, but also by some percents of nitrogen contained in the oxide and nitride film. The Kr content in the oxide and nitride film is 1/10 or less of the content in the oxide film, and the content of nitrogen is larger than that of Kr. That is, since the hydrogen content is small in the oxide and nitride film, the rate of weak couplings in the silicon nitride film decreases, and the contained nitrogen moderates the stress in the film, Si/SiO$_2$, or on the interface. As a result, it is considered that the charge in the film and the interface level density decrease, and the electric characteristic of the oxide and nitride film has been largely improved.

The desired result obtained by forming an oxide film or an oxide and nitride film is not only caused by removing the terminated hydrogen, but also caused by containing Ar or Fr in the nitride film or the oxide and nitride film. That is, in the nitride film obtained in the above-mentioned semiconductor production process, the stress in the nitride film of on the silicon/nitride film interface is moderated by Ar or Kr contained in the nitride film. As a result, the fixed charge in the silicon nitride film and the interface level density are reduced, and the electric characteristic, and especially the 1/f noise is reduced, thereby largely improving the reliability.

The inert gas used in the above-mentioned semiconductor production process is not limited to an Ar gas, a Kr gas, but a xenon Xe gas can also be used.

Furthermore, after forming a silicon oxide film and a silicon nitride film, the pressure in a vacuum container 1 is maintained at 133 Pa (1 Torr), a gas of a mixture of Kr/NH$_3$ at a partial pressure ratio of 98/2 is introduced, and about 0.7 nm silicon nitride film can be formed on the surfaces of a silicon oxide film and a silicon oxide and nitride film.

Thus, a silicon oxide film having a silicon nitride film formed on the surface, or a silicon oxide and nitride film can be obtained. Therefore, an insulating film having a high dielectric constant can be formed.

To realize the above-mentioned semiconductor production process, in addition to the device shown in Fig. 1, another plasma process device capable of forming a low temperature oxide film using plasma can be used. For example, it is possible to use a 2-stage shower plate type plasma process device having the first gas emission structure of emitting an Ar or Kr gas for pumping plasma, and a second gas emission structure which is different from the first gas emission structure and emits an O$_2$, NH$_3$, or N$_2$/H$_2$ gas.

Described below is the semiconductor production process according to an embodiment of the present invention.

The semiconductor process forms a gate insulating film of a MIS field-effect transistor on the surface (100) and the surface (110).

When a p-channel transistor is formed on the surface (111), 1.3 times the current drive capability of the surface (100) is obtained. If it is formed on the surface (110), 1.8 times the current drive capability of the surface (100) is obtained.

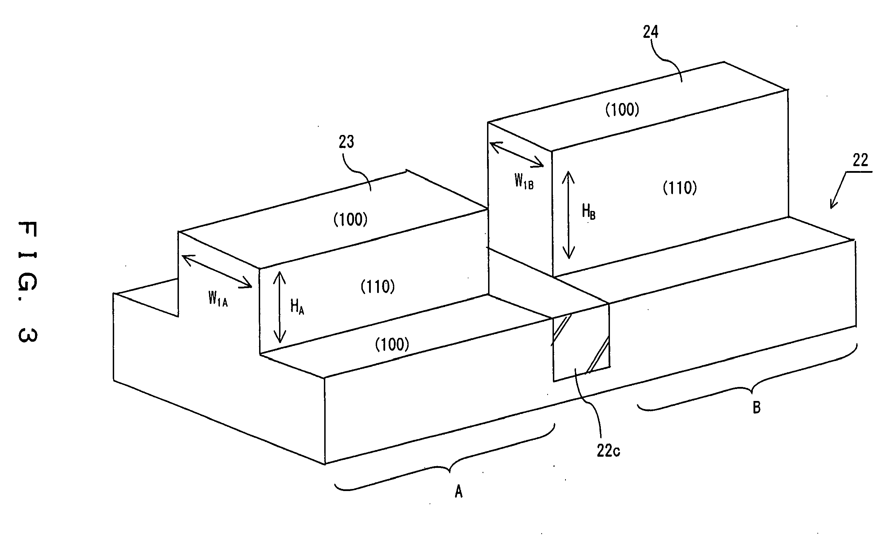

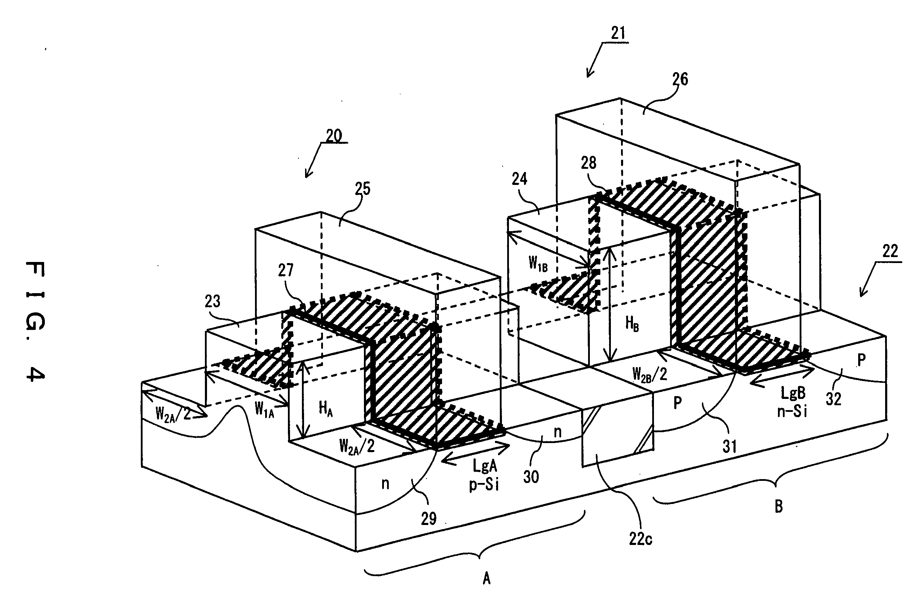

Fig. 3 shows the state of forming projecting portions 23 and 24 having surfaces (100) and (110) on a silicon substrate 22 in the semiconductor production process according to an embodiment of the present invention. Fig. 4 shows the structures of an n-channel MOS transistor 20 and a p-channel MOS transistor 21 produced in the semiconductor production process according to an embodiment of the present invention. Fig. 4 shows a channel formed at the lower portion of the gate oxide film and indicated by diagonal lines.

As shown in Fig. 3, the silicon substrate 22 having the surface (100) as a primary surface is separated by a device separation area 22c into p-type area A and an n-type area B. In the area A, the rectangular parallelepiped projecting portion 23 having a height of $H_A$ and a width of $W_{1A}$ is formed on the reference of the surface (100). Similarly, in the area B, the projecting portion 24 having a height of $H_B$ and a width of $W_{1B}$ is formed.

As shown in Fig. 4, a silicon oxide film is formed in the semiconductor production process on the surface of the silicon substrate 22 and the top surfaces and the side surfaces of the projecting portions 23 and 24.

On the silicon oxide film, polysilicon gate electrodes 25 and 26 are formed, the silicon oxide film is patterned when the polysilicon gate electrodes 25 and 26 are formed, and gate insulating films 27 and 28 are formed below the polysilicon gate electrodes 25 and 26.

In addition, an n-type impure ion is injected into the areas on both sides of the gate electrode 25 of the p-type area A, thereby forming n-type diffusion areas 29 and 30 including the projecting portion 23. The n-type diffusion areas 29 and 30 configure the source and the drain of the n-channel MOS transistor 20. Also in the n-type area B, a p-type impure ion is injected into the areas on both sides of the gate electrode 26, thereby forming p-type diffusion areas 31 and 32 including the projecting portion 24. The p-type diffusion areas 31 and 32 configure the source and drain of the p-channel MOS transistor 21.

When a predetermined voltage is applied to the gate electrodes 25 and 26 of the p-channel MOS transistor 21 and the n-channel MOS transistor 20, a channel indicated by the diagonal lines shown in Fig. 4 is formed below the gate oxide films 27 and 28.

The gate width of the surface (100) of the n-channel MOS transistor 20 is $W_{1A}$ on the top surface (top surface of the projecting portion 23) of the projecting portion 23, and $W_{2A}/2$ on the flat portions of the silicon substrate 22 on the right and left below the projecting portion 23. Therefore, it is a total of $W_{1A}+ W_{2A}$. Similarly, the gate width of the surface (110) of the n-channel MOS transistor 20, that is, the gate widths of the left and right side surfaces of the projecting portion 23 are $H_A$. Therefore, it is a total of $2H_A$. The gate width corresponds to the channel width. The gate length of the n-channel MOS transistor 20 is LgA.

Accordingly, the current drive capability of the n-channel MOS transistor 20 is expressed by $\mu_{n1} (W_{1A} + W_{2A}) + \mu_{n2} \cdot 2H_A$. The $\mu_{n1}$ indicates the electron mobility on the surface (100) and $\mu_{n2}$ indicates the electron mobility on the surface (110).

Similarly, the gate width of the surface (100) of the p-channel MOS transistor 21 is $W_{1B}$ on the top surface of the projecting portion 24, and $W_{2B}/2$ at the flat portions of the silicon substrate 22 on the left and right below the projecting portion 24 respectively. Therefore, it is a total of $W_{1B} + W_{2B}$. The gate width of the surface (110) of the p-channel MOS transistor 21, that is, the gate widths on the left and right side surfaces of the projecting portion 24 are $H_B$. As a result, the gate width is a total of $2H_B$. The gate width corresponds to the channel width. The gate length of the p-channel MOS transistor 21 is LgB.

Therefore, the current drive capability of the p-channel MOS transistor 21 can be expressed by $\mu_{p1} (W_{1B} + W_{2B}) + \mu_{p2} \cdot 2H_B$. The $\mu_{p1}$ indicates the Hall mobility on the surface (100), and $\mu_{p2}$ indicates the Hall mobility on the surface (110).

Thus, by setting the respective heights $H_A$ and $H_B$ of the projecting portions 23 and 24, the current drive capability of the p-channel MOS transistor 21 and the current drive capability of the n-channel MOS transistor 20 can be balanced. This condition can be expressed by the following equation.

$$\mu_{n1} \ (W_{1A} + W_{2A}) + \mu_{n2} \cdot 2H_A = \mu_{p1} \ (W_{1B} + W_{2B}) + \mu_{p2} \cdot 2 \ H_B$$

By setting the $H_A$ and $H_B$ to the values satisfying the equation above, the current drive capability of the p-channel MOS transistor 21 and the current drive capability of the n-channel MOS transistor 20 can be balanced. In this case, it is not necessary that the channel width of the primary surface (for example, the surface (100)) of the p-channel MOS transistor 21 is to be exceedingly larger than the channel width on the surface (100) of the n-channel MOS transistor 20. Therefore, the difference in parasitic capacity by a gate insulating film can be smaller between them. Thus, when a circuit of a CMOS structure is configured using the p-channel MOS transistor 21 and the n-channel MOS transistor 20, the current value imbalance caused when a parasitic capacity by the gate oxide film of the above transistors is charged or discharged can be reduced, and the noise level caused when the transistor of the CMOS structure is switched can be lowered.

The height $H_B$ of the p-channel MOS transistor 21 can be set such that, after setting the height $H_A$ of the gate of the n-channel MOS transistor 20 to "0", the current drive capability of the p-channel MOS transistor 21 can be substantially equal to the current drive capability of the n-channel MOS transistor 20.

Since the area of the gate on the primary surface (for example, the surface (100)) of the silicon substrate of the p-channel or the n-channel MOS transistor can be smaller than in the conventional semiconductor production process when the p-channel MOS transistor 21 or the n-channel MOS transistor 20 is individually formed, the area on the primary surface on the silicon substrate of the p-channel MOS transistor and the n-channel MOS transistor can be smaller, thereby enhancing the integration of a semiconductor circuit. Furthermore, since the parasitic capacities of the p-channel and N-channel MOS transistors can be smaller, the switching speed of the MOS transistors can be increased, and the power consumption at the switching can be reduced.

The insulating film formed on the silicon surface is not limited to an oxide film, but a silicon nitride film, a silicon oxide and nitride film, etc. can be formed.

Described below is the case where a limiter circuit is formed on a semiconductor circuit substrate in the above-mentioned semiconductor production process.

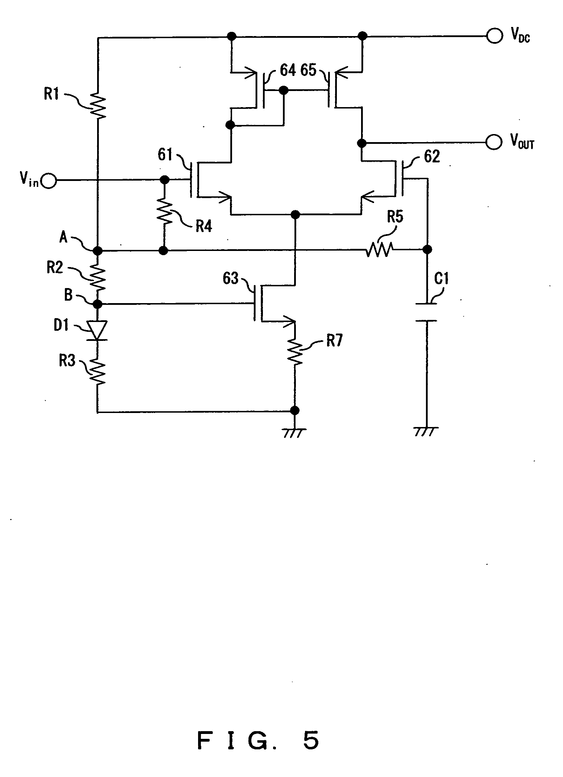

Fig. 5 shows an example of a limiter circuit. To the gate of the MOS transistor 61, a voltage obtained by dividing a power supply voltage VDC by the resistors R1 and R2, the diodes D1, and a the resistor R3 (voltage at the point A shown in Fig. 5) is applied through the resistor R4.

Also to the gate of the n-channel MOS transistor 62, the voltage obtained by dividing the power supply voltage VDC by the resistors R1 and R2, the diode D1, and the resistor R3 is applied through the resistor R5. To the gate of the MOS transistor 62, a terminal of the capacitor C1 is connected, and the other terminal of the capacitor C1 is grounded.

The input voltage Vin is input to the gate of the MOS transistor 61, and the input voltage Vin is input to the gate of the MOS transistor 62 through the serially connected resistors R4 and R5. These MOS transistors 61 and 62 configure a differential amplification circuit.

The drain and gate of the MOS transistor 64 of the p-channel MOS transistor 64 are connected to the drain of the MOS transistor 61, and the source of the MOS transistor 64 is connected to the power supply VDC.

The drain of the p-channel MOS transistor 65 is connected to the drain of the MOS transistor 62, and the gate of the MOS transistor 65 is connected to the gate of the MOS transistor 64. The source of the MOS transistor 65 is connected to the power supply voltage VDC. The MOS transistors 64 and 65-configure the constant current circuit as a load of the MOS transistors 61 and 62.

The voltage (at the point B shown in Fig. 5) obtained by dividing the power source voltage VDC by the resistors R1 and R2, the diodes D2, and the resistor R3 is applied to the gate of the n-channel MOS transistor 63. The source of the MOS transistor 63 is grounded. The MOS transistor 63 functions as a constant current source.

The operation of the above-mentioned circuit is explained as follows. That is, the input voltage Vin is input to the gate of the MOS transistor 61, and a voltage having a phase difference obtained from the input voltage Vin depending on the resistors R4 and R5 and the capacitor C1 is input. The positive amplitude of the drain voltage of the MOS transistor 62 is limited to a constant value when the amplitude of the input voltage Vin input to the gate of the MOS transistor 62 is a positive constant value or larger, and the amplitude of the drain voltage is limited to a negative constant value when the input voltage Vin input to the gate is a negative constant value or less. Thus, the voltage obtained by limiting the amplitude of the input voltage Vin is output from the drain of the MOS transistor 62.

By three-dimensionally structuring the gate of the MOS transistor of the limiter circuit and forming a gate oxide film in a low temperature plasma atmosphere, the influence of the channel length modulation effect of the differential amplification circuit comprising the MOS transistors 61 and 62 can be reduced, and the distortion of the signal in the limiter circuit can be decreased. Since the influence of the channel length modulation effect of the constant current circuit (comprising the MOS transistors 64) at the source and the current mirror circuit (comprising the MOS transistor 64 and 65) at the drain functioning as a load of the differential amplification circuit can be reduced, the fluctuation of the drain current depending on the change of the drain voltage can be reduced.

The limiter circuit is normally configured by a plurality of serially connected amplification circuits. Each amplification circuit comprises a differential amplification circuit, a constant current circuit functioning as a load, a constant current circuit commonly connected to the grounding terminal of the differential amplification circuit, etc.

According to the above-mentioned limiter circuit, by decreasing the damage on the silicon surface and leveling the surface, the variance of the characteristic of a MOS transistor (for example, a threshold voltage, etc.) can be reduced.

Thus, the DC offset and 1/f noise generated in the limiter circuit can be reduced, and the gain of the limiter circuit can be designed large.

Furthermore, the influence of the channel length modulation effect of the amplification circuit and the constant current circuit formed by the MOS transistors can be suppressed and the distortion of a signal in the limiter circuit can be decreased by forming the gate in a three-dimensional structure and the gate insulating film in the low temperature plasma atmosphere.

Additionally, the current drive capability of the MOS transistor of the limiter circuit can be improved, and the device area of the transistor on the primary surface of the silicon substrate can be smaller.

A limiter circuit can also be configured by a CMOS circuit comprising an n-channel MOS transistor and a p-channel MOS transistor. In this case, the parasitic capacity of the p-channel MOS transistor can be substantially equal to the parasitic capacity of the n-channel MOS transistor. Therefore, the noise due to the imbalance of a current when a transistor is turned ON or OFF can be decreased.

The p-channel MOS transistor and the n-channel MOS transistor used in, for example, the DC amplifier, the A/D conversion circuit, the digital circuit, etc. other than the limiter circuit can be produced in the above-mentioned semiconductor process.

With the above-mentioned configuration, since the characteristics of the p-channel MIS field-effect transistor and the n-channel MIS field-effect transistor of other circuits can be prepared, the DC offset and the 1/f noise of the entire circuit can be reduced.

Furthermore, the channels of the p-channel MOS transistors and the n-channel MOS transistors of the limiter circuit or other circuits are formed on different crystal surfaces (for example, the surfaces (100) and (110)) of silicon, and the channel width can be designed such that the current drive capability of a p-channel MOS transistor can be substantially equal to the current drive capability of a n-channel MOS transistor.

With the above-mentioned configuration, the parasitic capacity of the p-channel MOS transistor can be substantially equal to the parasitic capacity of the n-channel MOS transistor. Accordingly, the switching characteristic can be improved, and the noise generated by a current when the MOS transistors are turned ON or OFF can be reduced.

The present invention is not limited to the above-mentioned embodiments, but can also be configured as follows.

A limiter circuit is not limited to the circuits according to the above-mentioned embodiments, but can be any other well-known circuits.

The crystal surface of silicon is not limited to a combination of the surfaces (100) and (110), but can be a combination with another crystal surface such as the surfaces (100) and (111).

According to the present invention, since the DC offset and the 1/f noise generated in the limiter circuit can be reduced, a capacitor, etc. for cutting the AC component is not required. Furthermore, the influence of the channel length modulation effect can be reduced, and the distortion of a signal in the limiter circuit can be decreased. Additionally, the DC offset and the 1/f noise of other circuits connected to the limiter circuit can also be reduced.

**Claims**

1. A limiter circuit formed on a semiconductor integrated circuit substrate, comprising:

   a differential amplification circuit comprising an MIS field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion.

2. The limiter circuit according to claim 1, wherein a channel is formed on the first crystal surface of the top surface and the second crystal surface of the side surface of the projecting portion, and a channel width of the MIS field-effect transistor is at least a total of channel widths on the top surface and the side surface.

3. The limiter circuit according to claim 1 or 2, wherein the projecting portion has the top surface comprising a silicon surface (100), a side surface comprising a silicon surface (110), and the source and drain are formed on the projecting portion enclosing the gate and in left and right areas of the projecting portion of the silicon substrate.

4. The limiter circuit according to claim 1 or 2, wherein the frequency conversion circuit comprises a p-channel MIS field-effect transistor and n-channel MIS field-effect transistor, and a gate width of a top surface and a side surface of a projecting portion of the p-channel MIS field-effect transistor is set such that current drive capability of the p-channel MIS transistor can be substantially equal to current drive capability of the n-channel MIS transistor.

5. The limiter circuit according to claim 1 or 2, wherein
the limiter circuit comprises first and second MIS field-effect transistors forming a differential amplification circuit for receiving an FM-modulated signal at a gate, and a thirdMIS field-effect transistor forming a constant current circuit commonly connected to a source or a drain of the first and second MIS field-effect transistors.

6. A semiconductor integrated circuit comprising on a same circuit substrate:

a circuit comprising a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least one of the top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and
a limiter circuit comprising a differential amplification circuit having the p-channel MIS field-effect transistor or the n-channel MIS field-effect transistor.

7. The semiconductor integrated circuit according to claim 6, wherein
gate widths of the top surface and the side surface of the p-channel MIS field-effect transistor and the n-channel MIS field-effect transistor are set such that the current drive capability of the p-channel MIS field-effect transistor can be substantially equal to current drive capability of the n-channel MIS field-effect transistor.

8. The semiconductor integrated circuit according to claim 6 or 7, wherein
the limiter circuit comprises a CMOS circuit having the p-channel MIS field-effect transistor and the n-channel MIS field-effect transistor.

F I G. 1

INTERFACE LEVEL DENSITY

F I G. 2

F I G. 3

F I G. 4

F I G. 5

## INTERNATIONAL SEARCH REPORT

| International application No. |
| --- |
| PCT/JP2004/008219 |

**A. CLASSIFICATION OF SUBJECT MATTER**
Int.Cl$^7$ H01L27/092, H03G11/00, H03K5/00, H01L29/78, H01L21/336

According to International Patent Classification (IPC) or to both national classification and IPC

**B. FIELDS SEARCHED**

Minimum documentation searched (classification system followed by classification symbols)
Int.Cl$^7$ H01L27/092, H03G11/00, H03K5/00, H01L29/78, H01L21/336

Documentation searched other than minimum documentation to the extent that such documents are included in the fields searched
Jitsuyo Shinan Koho          1922–1996    Jitsuyo Shinan Toroku Koho    1996–2004
Kokai Jitsuyo Shinan Koho    1971–2004    Toroku Jitsuyo Shinan Koho    1994–2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | JP 2002-118255 A (Toshiba Corp.),<br>19 April, 2002 (19.04.02),<br>Full text; all drawings<br>& US 2002/011612 A1<br>Full text; all drawings | 1-3,5,6,8<br>4,7 |
| Y<br>A | JP 2002-261097 A (Tadahiro OMI),<br>13 September, 2002 (13.09.02),<br>Full text; all drawings<br>& EP 1347506 A1<br>Full text; all drawings<br>& WO 2002/054473 A1      & JP 2002-261091 A<br>& KR 3068570 A | 1-3,5,6,8<br>4,7 |

[X] Further documents are listed in the continuation of Box C.          [ ] See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>06 August, 2004 (06.08.04) | Date of mailing of the international search report<br>24 August, 2004 (24.08.04) |
| --- | --- |
| Name and mailing address of the ISA/<br>Japanese Patent Office | Authorized officer |
| Facsimile No. | Telephone No. |

Form PCT/ISA/210 (second sheet) (January 2004)

15

# EP 1 635 392 A1

## INTERNATIONAL SEARCH REPORT

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 6-303065 A (Nippon Telegraph And Telephone Corp.),<br>28 October, 1994 (28.10.94),<br>Full text; all drawings<br>& US 5475342 A<br>Full text; all drawings<br>& EP 621686 A2 &  JP 6-310967 A<br>& JP 7-46092 A | 1-3,5,6,8<br>4,7 |

Form PCT/ISA/210 (continuation of second sheet) (January 2004)